# EUROPEAN PATENT SPECIFICATION

(11) **EP 3 549 175 B1**
(45) Date of publication and mention of the grant of the patent: **21.04.2021**
(21) Application number: 17805242.9
(22) Date of filing: 22.11.2017
(51) Int. Cl.: H01L 31/0392, H01L 31/0352

(54) **OPTOELECTRONIC DEVICE**
OPTOELEKTRONISCHE VORRICHTUNG
DISPOSITIF OPTOÉLECTRONIQUE

(30) Priority: 01.12.2016 GB 201620420
(43) Date of publication of application: 09.10.2019
(73) Proprietor: Power Roll Limited, Sunderland Tyne and Wear SR5 3NZ (GB)
(72) Inventor: TOPPING, Alexander John, Sunderland Tyne and Wear SR5 3NZ (GB)
(74) Representative: HGF
(86) International application number: PCT/GB2017/053501
(87) International publication number: WO 2018/100337

(56) References cited:
- US-A1- 2015 372 176
- US-A1- 2016 172 514

## Description

The present invention relates to an optoelectronic device and more specifically a solar photovoltaic cell.

The term photovoltaic refers to the production of electricity, normally direct electrical current, from light at the junction between two materials that are exposed to the light. The light is normally sunlight and therefore photovoltaic is often referred to as solar photovoltaic. It is known to use semiconductors for the two materials. The semiconductor materials used exhibit a photovoltaic effect.

The two materials are usually semiconductors, a p-type and an n-type semiconductor material. When joined together the boundary or interface between the two types of semiconductor material is referred to as a p-n junction. This type of p-n junction is usually created by doping one material with the other material. The doping may be by diffusion, ion implantation or epitaxy. The later involves growing a second layer of crystal doped with one type of dopant on top of a first layer of crystal doped with a different type of dopant.

The p-n junction can be found in most optoelectronic devices that use semiconductors. These optoelectronic devices include photovoltaic or solar photovoltaic cells, diodes, light-emitting diodes (LEDs) and transistors. The p-n junction can be thought of as the active site where the generation or consumption of electrical energy occurs.

The demand for sources of renewable energy has driven significant improvements in the cost and efficiency of solar photovoltaic cells but existing technology still represents a relatively expensive method of generating electricity, especially because the cost of manufacture is relatively high. Also, existing solar photovoltaic cells are relatively inefficient compared to other methods of generating electricity, are relatively fragile, that is they are relatively easily damaged and relatively difficult to manufacture. US2016172514 discloses a photovoltaic device with an array of microstructures with cylindrical outer periphery. US2015372176 discloses an optoelectronic device comprising a substrate having a first and second series of grooves. The present invention aims to mitigate one or more of the disadvantages of existing solar photovoltaic cells.

In accordance with a first aspect of the present invention there is provided an optoelectronic device comprising:
a substrate having a three-dimensional array of peaks and troughs;
each peak having a first and a second face;
the troughs at least partially filled with a first semiconductor material; and
the first face of each peak coated with a conductor material and the second face of each peak coated with a second semiconductor material
wherein the first semiconductor material in the troughs, second semiconductor material on the second face and conductor material on at least the first face of each peak are all in electrical communication, such that an electrical current can flow between the first and second semiconductor materials and the conductor material..

It may be an advantage of the present invention that filing the troughs with the first semiconductor material may be easier than filing other structures, including grooves of a grooved structure. The three-dimensional array of peaks and troughs may be and/or may be referred to as, a series of surface perturbations. It may be an advantage of the present invention that the series of surface perturbations of the three-dimensional array of peaks and troughs is easier to fill than a substrate comprising a series of grooves.

The optoelectronic device is typically a solar photovoltaic cell.

The three-dimensional array of peaks and troughs may be referred to as a convoluted shaped surface.

The peaks may be cones and/or cone shaped. The peaks may have a pointed or a rounded apex or vertex. The peaks may have a circular or triangular or square base or regular or irregular polygonal base. The peaks typically have a circular base with radius r. All the peaks may have the same radius r or the radius r may vary. The radius r may be from 6 microns to 300 nanomaters, normally from 3 microns to 300 nanometers and typically from 1.5 microns to 500 nanometers.

The substrate provides a substantially planar surface and the troughs typically extend a first distance from the substantially planar surface and the peaks typically extend a second distance from the substantially planar surface. The first and second distances are typically the same. The first and second distances are typically measured from a half way point between a bottom of the troughs and a top or apex of the peaks.

The second distance the peaks extend from the substantially planar surface may be referred to as the height of the peaks. The height of the peaks is typically related and/or dependent on the size of the base of the peaks. The height of the peaks is typically from 0.3 to 10µm, normally from 0.3 to 6µm. The width of the base of the peaks is typically from 0.3 to 10µm, normally from 0.3 to 6µm.

The distance between the apex or vertex of two peaks may be substantially the same, typically the same. The distance between the apex or vertex of two peaks is typically from 0.3 to 100µm, normally from 0.3 to 5µm. The distance between the apex or vertex of two peaks typically defines the trough.

The peaks may be square. That is the base of the peak is square and the top of what would be the apex or vertex of the peak is also square. The peaks may be polygonal shapes and/or polygonal in shape.

The troughs are at least partially filled with the first semiconductor material.

The substrate may be divided up into more than one portion. There may be a channel that separates a first portion of the substrate from a second portion of the substrate. The channel typically transects the peaks and troughs thereby defining and/or separating the first portion of the substrate from the second portion of the substrate.

It may be an advantage of the present invention that the channel separates the first and second portions of the substrate such that an electrical current can be taken from or supplied to the first portion in isolation from the second portion.

The first and face of each peak is coated with the conductor material. The second face of each of the peaks is coated with the second semiconductor material.

The second face may be coated with the second semiconductor material and the first face coated with a third semiconductor material. The third semiconductor is typically a proton conductor. The third semiconductor may be molybdenum oxide.

The first and second faces of each of the peaks are normally at a first angle relative to a normal from the substrate. The angle is normally from 45 to less than 90°.

The first semiconductor material may be an intrinsic semiconductor. The first semiconductor material is typically a p-type semiconductor material. The second semiconductor material is typically an n-type semiconductor material. In an alternative embodiment the first semiconductor material is an n-type semiconductor material and the second semiconductor material is a p-type semiconductor material.

The n-type and p-type semiconductors may comprise one or more of silicon, amorphous silicon, hydrogenated amorphous silicon, aluminium, germanium, gallium nitride, gallium arsenide, aluminium phosphide, aluminium arsenide, copper iodide, zinc oxide, lead sulphide and any other semiconductor.

The n-type semiconductor typically comprises one or more of silicon, germanium, phosphorus, selenium, tellurium, titanium and compounds thereof and cadmium sulphide.

The p-type semiconductor typically comprises one or more of silicon, germanium, cadmium telluride, copper indium gallium selenide ('CIGS'), copper indium gallium diselenide, copper oxide, lead sulphide, lead oxide, copper zinc tin sulphide (CZTS), boron, beryllium, zinc and cadmium.

The first and second semiconductor materials may meet at an interface and/or boundary. The interface is typically referred to as a p-n junction. The interface is typically and/or may be referred to as a diode. The first and second semiconductor materials may together be referred to as an active material.

The first semiconductor may be a perovskite. The first semiconductor may comprise a perovskite or a perovskite material. The second semiconductor may comprise titanium oxide or other electron extraction layer. The inventors of the present invention appreciate that a perovskite in isolation is not typically referred to as a semiconductor, but in the context of the present invention, a perovskite or perovskite material can provide the optoelectronic device with the same function as the other first semiconductor materials described herein.

The active material may be deposited in the troughs and on a first and/or second face of each of the peaks to provide ohmic and rectifying contacts for insertion or extraction of charge from the active material. The active material may be one or more of photovoltaic, light emitting and ion conducting.

The substrate of the optoelectronic device typically provides an interconnected electrical circuit comprising the conductor material, the first and second semiconductor materials. The interconnected electrical circuit typically comprises a complex series of interconnected p-n junctions and/or diodes.

It may be an advantage of the present invention that the interconnected electrical circuit produces a higher voltage of electrical energy per unit surface area compared to other known optoelectronic devices.

The second face may be coated with a conductor material and the second semiconductor material. The conductor material coated on the first face may be the same as the conductor material coated on the second face but it may be different. The conductor material coated on the first and/or second face may comprise one or more of aluminium, bismuth, cadmium, chromium, tellurium, copper, gallium, gold, indium, lead, magnesium, manganese, samarium, scandium, silver, tin and zinc.

The second semiconductor material may be an electron blocking material such as molybdenum trioxide. The first semiconductor material may be a heterojunction, that is a mixture of one or more of a p-type semiconductor, n-type semiconductor and donor acceptor material.

The first semiconductor material in the troughs, second semiconductor material on the second face and conductor material on at least the first face of each peak are normally all in electrical communication. The electrical communication is such that normally an electrical current can flow between the first and second semiconductor materials and the conductor material.

The flow of electrical current between the first and second semiconductor materials and the conductor material is typically complex and/or multidirectional. The flow of electrical current is typically between neighbouring peaks, through neighbouring troughs.

In a first arrangement, the electrical current may flow between one or more of a first to a second peak; the first to a third peak; the first to a fourth peak; the first to a fifth peak; the first to a sixth peak; the first to a seventh peak; and first to an eighth peak. Each peak may be surrounded by any number of neighbouring peaks.

In a second arrangement, the electrical current may flow between one or more of a first to a second peak; the first to a third peak; and the first to a fourth peak. Each peak may therefore be surrounded by four nearest neighbouring peaks. There are typically another four further neighbouring peaks. The second arrangement may be and/or may be referred to as a square arrangement.

The peaks may be in and/or may be referred to as a triangular or diamond arrangement.

The three-dimensional array of peaks and troughs may be a random distribution of peaks and troughs. That is to say the distribution of the peaks across the surface of the substrate is random and therefore the space between neighbouring peaks is varied and the size and/or shape of the troughs is varied. The three-dimensional array of peaks and troughs may be a pseudo random distribution of peaks and troughs.

The optoelectronic device may be referred to as a two terminal device. In use the device may be operated in a combined series and parallel arrangement.

The first semiconductor material in the troughs may be from 50 to 1000nm deep and/or thick, normally from 100 to 500nm deep and/or thick and typically from 100 to 200nm deep and/or thick.

The second semiconductor material on the second face of the peaks may be from 10 to 1000nm deep and/or thick, normally from 10 to 500nm deep and/or thick and typically from 10 to 200nm deep and/or thick.

The conductor material on the first face of the peaks may be from 20 to 1000nm deep and/or thick, normally from 30 to 500nm deep and/or thick and typically from 30 to 200nm deep and/or thick.

It may be an advantage of the present invention that when the first semiconductor depth and/or thickness is about 200nm, one or more of the efficiency, electrical current generated, power output and photoelectric conversion efficiency of the optoelectronic device is increased. When the second semiconductor thickness is about 200nm, the width of the trough may be about 1 µm, although this may vary for different arrays and/or arrangements of peaks and troughs.

One or more of the efficiency, electrical current generated, power output and photoelectric conversion efficiency of the optoelectronic device may be increased further if the thickness of the second semiconductor is about 200 to 500nm thick and the conductor material and/or second semiconductor material coats and/or covers about 50% of the first face and/or second face of each peak respectively, when the trough is v-shaped or u-shaped, 1 µm deep and 1 µm wide. One or more of the efficiency, electrical current generated, power output and photoelectric conversion efficiency of the optoelectronic device may be yet further increased if the first semiconductor material occupies about 40% of the volume of the trough and the conductor material and/or second semiconductor material coats and/or covers about 50% of the first face and/or second face of the peaks respectively.

The troughs may be any shape, typically semi-spherical. The troughs may have a flat bottom.

The inventor of the present invention has appreciated that, in contrast to the usual trend towards reducing the cost and increasing the efficiency of optoelectronic devices, if the costs are significantly reduced, may be by up to an order of magnitude, then the efficiency is less important. When the optoelectronic device is a solar photovoltaic cell, this is particularly useful if the durability of the solar photovoltaic cells can be improved so that installation is relatively easy and therefore low cost and the solar photovoltaic cells have a greater range of application.

The optoelectronic device according to the first aspect of the present invention may be one or more of attached, secured and applied to a vehicle, for example a car or lorry, a house, for example a roof, and any other surface of a permanent structure. The permanent structure may be man-made or natural.

A surface that the optoelectronic device is one or more of attached, secured and applied to may be flat or uneven, that is one or more of rough, bumpy, irregular and/or rutted. The surface may be part of a building including a house and/or a domestic roof.

The substrate may comprise a curable resin and in particular a UV curable resin. The substrate may comprise one or more of an acrylic resin coated onto polyvinyl chloride (PVC), acrylic resin coated onto polyethylene terephthalate (PET), acrylic resin coated onto polyethylene naphthalate (PEN), a biopolymer coated onto polyvinyl chloride (PVC), a biopolymer coated onto polyethylene terephthalate (PET) and a biopolymer coated onto polyethylene naphthalate (PEN).

The first and second faces of the peaks are normally configured to be coated by an off-axis directional coating process. The off-axis directional coating process may include spraying the conductor material and/or the second semiconductor material at an angle relative to the plane of the substrate, and therefore also each of the peaks such that only the first or second face of each peak is coated. This is typically because the coating is substantially restricted by viewing angle to only one of the first or second face.

The off-axis directional coating process may include using a shield to restrict the coating of the conductor material and/or the second semiconductor material onto the at least first and/or second face of each peak. The off-axis directional coating process may be repeated using more than one conductor material and/or semiconductor material.

The off-axis directional coating is typically performed in a partial vacuum. The partial vacuum normally ensures the coating material from a source has a sufficient mean free path, that is a direct and un-diverted path, and that the substrate is substantially free from interactions with gas or atmospheric molecules. The coating material may be the conductor material or the semiconductor material.

Generally the mean free path of travel of atomised coating material is comparable to the distance between the source and the surface of the substrate to be coated. Off-axis directional coating in a partial vacuum, also referred to as vacuum evaporation coating, at pressures below 10⁻⁴mbar is typically directional due to the mean free path being approximately 600mm. The source can be angled to the first or second substantially planar face of the substrate so that a restricted view of the surface of the substrate is presented and this restricted view allows for coating on selective parts of the substrate by a process of self-shadowing. The mean free path may also be defined as the length of a path an atom or molecule can travel before it is expected to have interacted with another atom or molecule. At atmospheric pressure the mean free path is typically 67nm. Calculated using nitrogen as the total atmosphere and a partial vacuum level of 0.0001 mbar, the mean free path is typically 66cm. At a partial vacuum of 0.00001 mbar, the mean free path increases to 6.6 meters.

The conductor material and/or the second semiconductor material may be sprayed onto and/or towards the substrate at an angle relative to the plane of the substrate of from 25 to 90°, normally from 35 to 55°, and typically 45°. The angle at which the conductor material or second semiconductor material is sprayed onto and/or towards the first face of the peaks, may be the same, typically different from the angle at which the conductor material or second semiconductor material is sprayed onto and/or towards the second face of the peaks.

The first semiconductor may be put into the troughs by printing, inkjet printing, rotary screen printing, spraying, spray coating, ultrasonic spray coating, rotary gravure, doctor blade, rotary screen printing, slot die, reverse gravure, offset printing, offset lithographic printing, roller, calendar roller, powder coating and electrospray.

An embodiment of the invention will now be described by way of example only and with reference to the accompanying drawings, in which:
Figure 1 is a perspective view of the surface of the substrate of the optoelectronic device;
Figure 2 is a cross-sectional view of the surfaces shown in Figure 1, with the addition of a channel that separates a first and second portion of the substrate;
Figure 3a and 3b are schematic circuit diagrams of electrical circuits of optoelectronic devices, as shown in Figures 1 and 2;
Figure 4 is a schematic circuit diagram of an electrical circuit of another optoelectronic device; and
Figure 5 is a schematic circuit diagram of the diode of the electrical circuits shown in Figures 3a, 3b and 4.

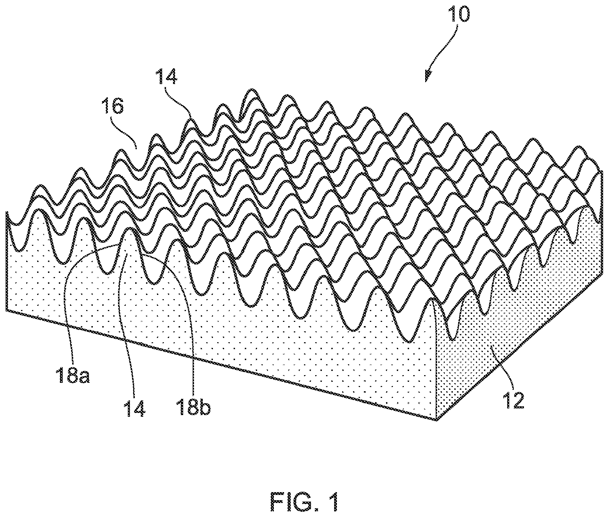

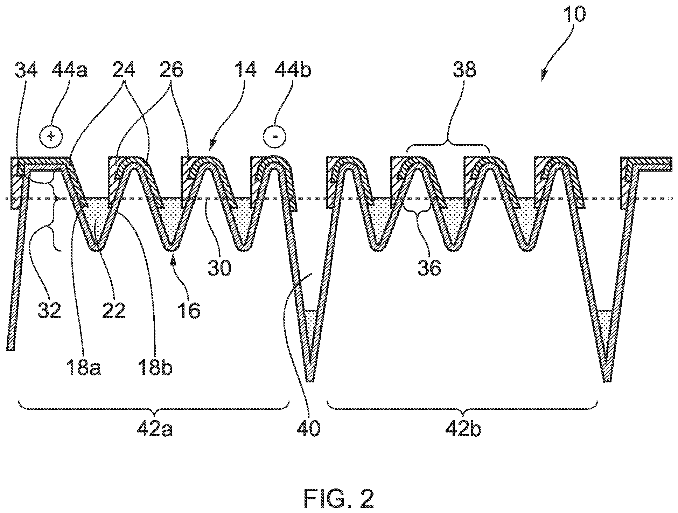

Figure 1 shows an optoelectronic device 10 comprising a substrate 12 having a three-dimensional array of peaks 14 and troughs 16. Each peak 14 has a first 18a and a second face 18b. Figure 2 is a cross-sectional view of the optoelectronic device 10. The troughs 16 contain a first semiconductor material 22 and the first face 18a of each peak 14 is coated with a conductor material 24 and the second face 18b of each peak 14 is coated with a second semiconductor material 26.

The optoelectronic device 10 is a solar photovoltaic cell.

Figure 2 shows the substrate 12 provides a substantially planar surface 30. The troughs 16 extend a first distance 32 from the substantially planar surface and the peaks extend a second distance 34 from the substantially planar surface. The first 32 and second 34 distances are the same. The substantially planar surface 30 is denoted in Figure 2 as a median level between the top of the peaks 14 and the bottom of the troughs 16.

The first distance 32 is the depth of the trough. The trough is 5µm deep. The second distance 34 is the height of the peak. The peak is 5µm high. The width 36 of the base of the peaks 14 is 5µm.

The peaks 14 are cone shaped. The peaks 14 have a rounded apex. The peaks have a circular base with a radius of 5µm. The troughs 16 are semi-spherical.

Figure 2 shows the substrate is divided up into more than one portion. There is a channel 40 that separates a first portion 42a of the substrate from a second portion 42b of the substrate. The channel transects the peaks and troughs thereby defining and separating the first portion 42a from the second portion 42b. The channel 40 separates the first 42a and second 42b portions of the substrate such that an electrical current can be taken from the first portion 42a in isolation from the second portion 42b.

The first 42a, second 42b and other portions (not shown), all carry a positive charge 44a and a negative charge 44b. The positive 44a and negative 44b charges are either side of the first 42a and second 42b portions. The first 42a and second 42b portions are individual cells of electrical current. The electrical current flows between neighbouring peaks 14. The optoelectronic device 10 is as a two terminal device.

The first semiconductor material 22 is a p-type semiconductor material. The second semiconductor material 26 is an n-type semiconductor material.

Referring to Figures 1 and 2, the flow of electrical current between the first 22 and second 26 semiconductor materials and the conductor material 24 is complex and multidirectional. The flow of electrical current is between neighbouring peaks 14 and through neighbouring troughs 16.

The three-dimensional array of peaks 14 and troughs 16 shown in Figure 1 is regular. The optoelectronic device may however comprise a random distribution of peaks and troughs.

The troughs 16 shown in Figures 1 and 2 are u-shaped, 1µm deep measured from the top of the peaks and 1 µm wide measured at their widest point. The first semiconductor material 22 in the troughs 16 is 200nm deep, measured from what is shown as an upper surface of the material to the bottom of the trough. The conductor material 24 on the first face 18a of the peaks is 100nm thick at it thickest point. The second semiconductor material 26 on the second face 18b of the peaks is 100nm thick at its thickest point.

The conductor material 24 and the second semiconductor material 26 cover 50% of the first face 18a and second face 18b of each peak respectively.

The substrate is an acrylic resin coated onto polyvinyl chloride (PVC). The first 18a and second 18b faces of the peaks 14 are coated by an off-axis directional coating process. The off-axis directional coating process involves spraying the conductor material 24 and the second semiconductor material 26 at an angle relative to the plane of the substrate 12, and therefore also each of the peaks 14 such that only the first 18a or second face 18b of each peak 14 is coated.

The first semiconductor is put into the troughs by spray coating.

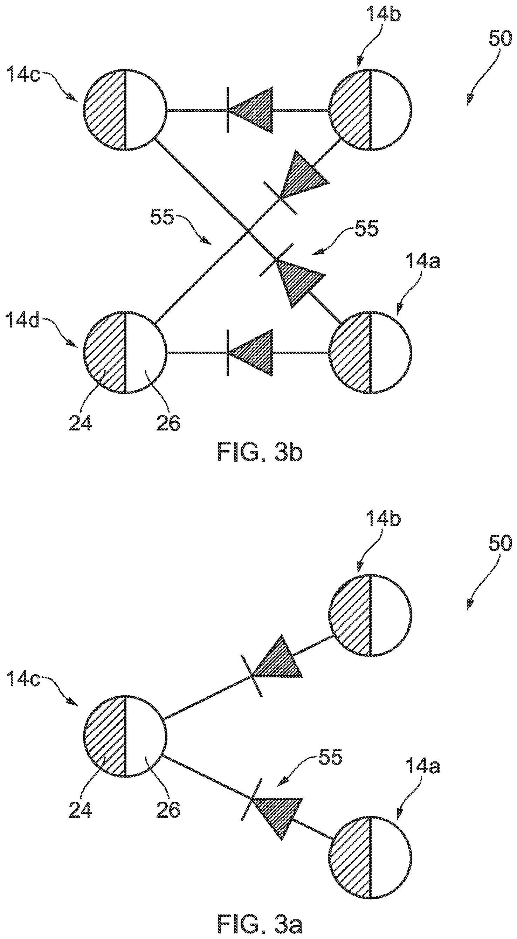

Figure 3a and 3b are schematic circuit diagrams 50 of electrical circuits of optoelectronic devices 10, as shown in Figures 1 and 2.

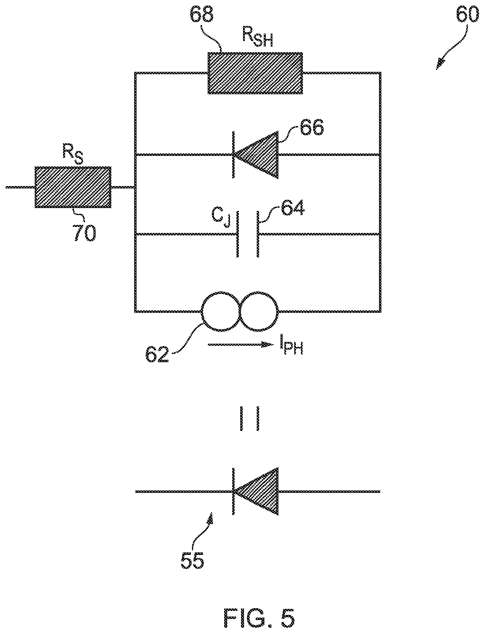

Figure 3a shows peaks 14 (14a, 14b and 14c). The first face of each peak 14 has a coat of (is coated with) the conductor material 24 and the second face of each peak 14 has a coat of (is coated with) the second semiconductor material 26. Arrow and symbol 55 is a representation of a diode. Further details of the diode 55 are provided in Figure 5. The first peak 14a has two neighbouring peaks 14b and 14c.

Figure 3b shows peaks 14 (14a, 14b, 14c and 14d). The first face of each peak 14 has a coat of (is coated with) the conductor material 24 and the second face of each peak 14 has a coat of (is coated with) the second semiconductor material 26. Arrow and symbol 55 is a representation of a diode. The first peak 14a has three neighbouring peaks 14b, 14c and 14d.

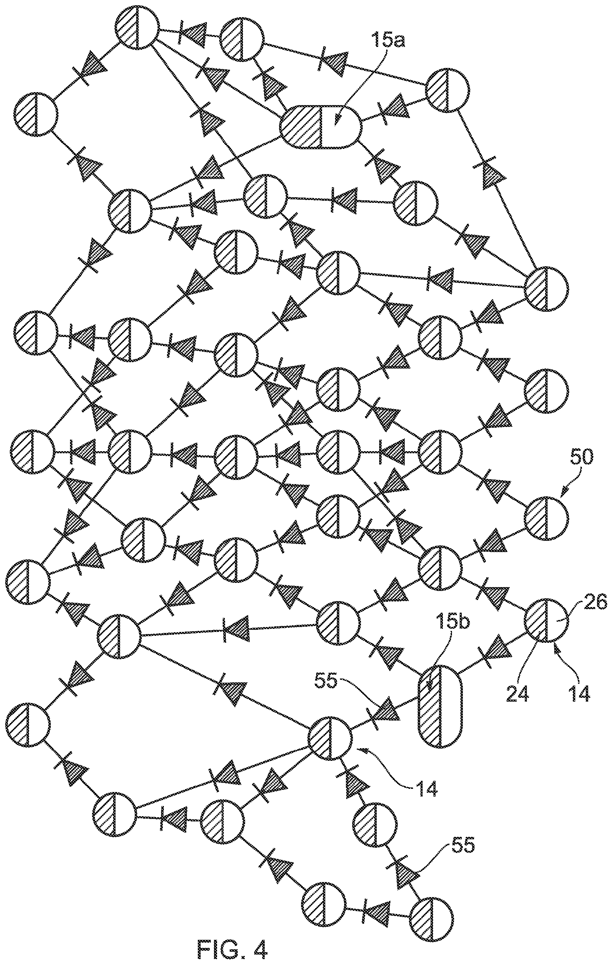

Figure 4 is a schematic circuit diagram of an electrical circuit 50 of another optoelectronic device. Figure 4 shows each peak 14 has a varying number of neighbouring peaks. The first face of each peak 14 has a coat of (is coated with) the conductor material 24 and the second face of each peak 14 has a coat of (is coated with) the second semiconductor material 26. Arrow and symbol 55 is a representation of a diode. The peaks 15a and 15b represent two neighbouring peaks that are close enough to be considered as one peak.

Figure 4 is an interconnected electrical circuit 50 comprising the conductor material 24, the first (not shown) and second 26 semiconductor materials. The interconnected electrical circuit comprises a complex series of interconnected p-n junctions and diodes 55.

Figure 5 is a schematic circuit diagram 60 of the diode 55 of the electrical circuits shown in Figures 3a, 3b and 4. The circuit diagram 60 of the diodes 55 in Figures 3a, 3b and 4 are a representation of an electrical circuit comprising a photo current source 62, capacitor 64, ideal diode 66, shunt resistor 68 and series resistor 70.

Modifications and improvements can be incorporated herein without departing from the scope of the invention.

## Claims

1. An optoelectronic device (10) comprising:
a substrate (12) having a three-dimensional array of peaks (14) and troughs (16);
each peak having a first and a second face (18a, 18b);
the troughs (16) at least partially filled with a first semiconductor material (22); and
the first face (18a) of each peak coated with a conductor material (24) and the second face of each peak coated with a second semiconductor material (26)
wherein the first semiconductor material (22) in the troughs, second semiconductor material (26) on the second face (18b) and conductor material (24) on at least the first face (18a) of each peak are all in electrical communication, such that an electrical current can flow between the first and second semiconductor materials and the conductor material.

2. An optoelectronic device (10) according to claim 1, wherein the peaks (14) are cone shaped.

3. An optoelectronic device (10) according to claim 1 or claim 2, wherein the height (34) of the peaks (14) is from 0.01 to 10µm and / or wherein the width (36) of the base of the peaks is from 0.01 to 10µm.

4. An optoelectronic device (10) according to any preceding claim, wherein the distance between apexes of two peaks is from 0.1 to 100µm.

5. An optoelectronic device (10) according to any preceding claim, further comprising a channel (40) that separates a first portion (42a) of the substrate (12) from a second portion (42b) of the substrate (12).

6. An optoelectronic device (10) according to any preceding claim, wherein the first and second faces (18a, 18b) of each peak are coated with the conductor material (24).

7. An optoelectronic device (10) according to any preceding claim, wherein the first and second faces (18a, 18b) of each of the peaks (14) are coated with the second semiconductor material (26).

8. An optoelectronic device (10) according to any preceding claim, wherein the first and second faces (18a, 18b) of each of the peaks (14) are at an angle of from 45 to less than 90° relative to a normal from the substrate (12).

9. An optoelectronic device (10) according to any preceding claim, wherein the first and second semiconductor materials (22, 26) together provide ohmic and rectifying contacts for insertion or extraction of charge.

10. An optoelectronic device (10) according to any preceding claim, wherein each peak is surrounded by any number of neighbouring peaks.

11. An optoelectronic device (10) according to any preceding claim, wherein the three-dimensional array of peaks (14) and troughs (16) is a random distribution of peaks and troughs.

12. An optoelectronic device (10) according to any preceding claim, wherein the first semiconductor material (22) in the troughs (16) is from 100 to 500nm deep.

13. An optoelectronic device (10) according to any preceding claim, wherein the second semiconductor material (26) on the second face of the peaks is from 100 to 500nm thick. and / or wherein the conductor material (24) on the first face of the peaks is from 100 to 500nm thick.

14. An optoelectronic device (10) according to any preceding claim, wherein the trough is one or more of v-shaped, u-shaped, semi-spherical, round-bottomed and flat-bottomed.

15. An optoelectronic device (10) according to any preceding claim, wherein the trough is 1µm deep and 1µm wide.

## Patentansprüche

1. Optoelektronische Vorrichtung (10), umfassend:
ein Substrat (12), das eine dreidimensionale Anordnung von Peaks (14) und Tälern (16) aufweist;
wobei jeder Peak eine erste und eine zweite Fläche (18a, 18b) aufweist;
wobei die Täler (16) zumindest teilweise mit einem ersten Halbleitermaterial (22) gefüllt sind; und
wobei die erste Fläche (18a) jedes Peaks mit einem Leitermaterial (24) beschichtet ist und die zweite Fläche jedes Peaks mit einem zweiten Halbleitermaterial (26) beschichtet ist,
wobei das erste Halbleitermaterial (22) in den Tälern, das zweite Halbleitermaterial (26) auf der zweiten Fläche (18b) und das Leitermaterial (24) auf zumindest der ersten Fläche (18a) jedes Peaks alle in elektrischer Kommunikation sind, sodass ein elektrischer Strom zwischen dem ersten und dem zweiten Halbleitermaterial und dem Leitermaterial fließen kann.

2. Optoelektronische Vorrichtung (10) nach Anspruch 1, wobei die Peaks (14) kegelförmig sind.

3. Optoelektronische Vorrichtung (10) nach Anspruch 1 oder Anspruch 2, wobei die Höhe (34) der Peaks (14) 0,01 bis 10 µm ist und/oder wobei die Breite (36) der Basis der Peaks 0,01 bis 10 µm ist.

4. Optoelektronische Vorrichtung (10) nach einem vorhergehenden Anspruch, wobei der Abstand zwischen Spitzen von zwei Peaks 0,1 bis 100 µm ist.

5. Optoelektronische Vorrichtung (10) nach einem vorhergehenden Anspruch, ferner umfassend einen Kanal (40), der einen ersten Abschnitt (42a) des Substrats (12) von einem zweiten Abschnitt (42b) des Substrats (12) trennt.

6. Optoelektronische Vorrichtung (10) nach einem vorhergehenden Anspruch, wobei die erste und die zweite Fläche (18a, 18b) jedes Peaks mit dem Leitermaterial (24) beschichtet sind.

7. Optoelektronische Vorrichtung (10) nach einem vorhergehenden Anspruch, wobei die erste und die zweite Fläche (18a, 18b) von jedem der Peaks (14) mit dem zweiten Halbleitermaterial (26) beschichtet sind.

8. Optoelektronische Vorrichtung (10) nach einem vorhergehenden Anspruch, wobei die erste und die zweite Fläche (18a, 18b) von jedem der Peaks (14) in einem Winkel von 45 bis weniger als 90° relativ zu einer Normalen von dem Substrat (12) sind.

9. Optoelektronische Vorrichtung (10) nach einem vorhergehenden Anspruch, wobei das erste und das zweite Halbleitermaterial (22, 26) zusammen ohmsche und gleichrichtende Kontakte zum Einfügen oder Extrahieren von Ladung bereitstellen.

10. Optoelektronische Vorrichtung (10) nach einem vorhergehenden Anspruch, wobei jeder Peak von einer beliebigen Anzahl an benachbarten Peaks umgeben ist.

11. Optoelektronische Vorrichtung (10) nach einem vorhergehenden Anspruch, wobei die dreidimensionale Anordnung von Peaks (14) und Tälern (16) eine zufällige Verteilung von Peaks und Tälern ist.

12. Optoelektronische Vorrichtung (10) nach einem vorhergehenden Anspruch, wobei das erste Halbleitermaterial (22) in den Tälern (16) 100 bis 500 nm tief ist.

13. Optoelektronische Vorrichtung (10) nach einem vorhergehenden Anspruch, wobei das zweite Halbleitermaterial (26) auf der zweiten Fläche der Peaks 100 bis 500 nm dick ist und/oder wobei das Leitermaterial (24) auf der ersten Fläche der Peaks 100 bis 500 nm dick ist.

14. Optoelektronische Vorrichtung (10) nach einem vorhergehenden Anspruch, wobei das Tal eines oder mehrere von v-förmig, u-förmig, halbkugelförmig, mit rundem Boden und mit flachem Boden ist.

15. Optoelektronische Vorrichtung (10) nach einem vorhergehenden Anspruch, wobei das Tal 1 µm tief und 1 µm breit ist.

## Revendications

1. Dispositif optoélectronique (10) comprenant :
un substrat (12) possédant un réseau tridimensionnel de pics (14) et de creux (16) ;
chaque pic possédant une première et une seconde face (18a, 18b) ;
les creux (16) au moins partiellement remplies d'un premier matériau semi-conducteur (22) ; et
la première face (18a) de chaque pic revêtue d'un matériau conducteur (24) et la seconde face de chaque pic revêtue d'un second matériau semi-conducteur (26)
ledit premier matériau semi-conducteur (22) dans les creux, ledit second matériau semi-conducteur (26) sur la seconde face (18b) et ledit matériau conducteur (24) sur au moins la première face (18a) de chaque pic étant tous en communication électrique, de sorte qu'un courant électrique puisse circuler entre les premier et second matériaux semi-conducteurs et le matériau conducteur.

2. Dispositif optoélectronique (10) selon la revendication 1, lesdits pics (14) étant en forme de cône.

3. Dispositif optoélectronique (10) selon la revendication 1 ou la revendication 2, ladite hauteur (34) des pics (14) étant de 0,01 à 10 µm et/ou ladite largeur (36) de la base des pics allant de 0,01 à 10 µm.

4. Dispositif optoélectronique (10) selon une quelconque revendication précédente, ladite distance entre les sommets de deux pics allant de 0,1 à 100 µm.

5. Dispositif optoélectronique (10) selon l'une quelconque des revendications précédentes, comprenant en outre un canal (40) qui sépare une première partie (42a) du substrat (12) d'une seconde partie (42b) du substrat (12).

6. Dispositif optoélectronique (10) selon l'une quelconque des revendications précédentes, lesdites première et seconde faces (18a, 18b) de chaque pic étant revêtues du matériau conducteur (24).

7. Dispositif optoélectronique (10) selon une quelconque revendication précédente, lesdites première et seconde faces (18a, 18b) de chacun des pics (14) étant revêtues du second matériau semi-conducteur (26).

8. Dispositif optoélectronique (10) selon l'une quelconque des revendications précédentes, lesdites première et seconde faces (18a, 18b) de chacun des pics (14) étant à un angle allant de 45 à moins de 90° par rapport à une normale du substrat (12).

9. Dispositif optoélectronique (10) selon une quelconque revendication précédente, lesdits premier et second matériaux semi-conducteurs (22, 26) fournissant ensemble des contacts ohmiques et redresseurs pour l'insertion ou l'extraction de charge.

10. Dispositif optoélectronique (10) selon l'une quelconque des revendications précédentes, chaque pic étant entouré par un nombre quelconque de pics voisins.

11. Dispositif optoélectronique (10) selon une quelconque revendication précédente, ledit réseau tridimensionnel de pics (14) et de creux (16) étant une distribution aléatoire de pics et de creux.

12. Dispositif optoélectronique (10) selon une quelconque revendication précédente, ledit premier matériau semi-conducteur (22) dans les creux (16) possédant une profondeur allant de 100 à 500 nm.

13. Dispositif optoélectronique (10) selon une quelconque revendication précédente, ledit second matériau semi-conducteur (26) sur la seconde face des pics possédant une épaisseur allant de 100 à 500 nm, et/ou ledit matériau conducteur (24) sur la première face des pics possédant une épaisseur allant de 100 à 500 nm.

14. Dispositif optoélectronique (10) selon une quelconque revendication précédente, ledit creux étant l'une ou plusieurs d'un creux en forme de V, d'un creux en forme de U, d'un creux semi-sphérique, d'un creux à fond rond et d'un creux à fond plat.

15. Dispositif optoélectronique (10) selon l'une quelconque des revendications précédentes, ledit creux possédant une profondeur de 1 µm et une largeur de 1 µm.
